(19) Europäisches Patentamt
European Patent Office
Office européen des brevets

(11) **EP 2 464 910 B1**

(12) **EUROPÄISCHE PATENTSCHRIFT**

(45) Veröffentlichungstag und Bekanntmachung des Hinweises auf die Patenterteilung:
**01.04.2015 Patentblatt 2015/14**

(21) Anmeldenummer: **10729850.7**

(22) Anmeldetag: **30.06.2010**

(51) Int Cl.:
***F21K 99/00*** *(2010.01)*

(86) Internationale Anmeldenummer:
**PCT/EP2010/059290**

(87) Internationale Veröffentlichungsnummer:
**WO 2011/018272 (17.02.2011 Gazette 2011/07)**

(54) **HALBLEITERLICHTQUELLE**

SEMICONDUCTOR LIGHT SOURCE

SOURCE LUMINEUSE À SEMI-CONDUCTEUR

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **13.08.2009 DE 102009037415**

(43) Veröffentlichungstag der Anmeldung:
**20.06.2012 Patentblatt 2012/25**

(73) Patentinhaber: **OSRAM Opto Semiconductors GmbH**
**93055 Regensburg (DE)**

(72) Erfinder: **KRUMMACHER, Benjamin Claus**
**93051 Regensburg (DE)**

(74) Vertreter: **Epping - Hermann - Fischer**
**Patentanwaltsgesellschaft mbH**
**Schloßschmidstraße 5**
**80639 München (DE)**

(56) Entgegenhaltungen:
**EP-A1- 1 569 283        DE-A1- 10 125 341**
**DE-A1-102006 019 857    DE-U1- 20 300 806**

## Beschreibung

Es wird eine Halbleiterlichtquelle angegeben.

In der Druckschrift DE 20 2008 010 884 U1 ist eine Leuchte angegeben.

Die Druckschrift EP 1 569 283 A1 betrifft eine LED mit einem optischen System zur Erhöhung einer Leuchtdichte.

Eine zu lösende Aufgabe besteht darin, eine Halbleiterlichtquelle anzugeben, die eine vorgebbare Abstrahlcharakteristik aufzeigt.

In der Druckschrift DE 101 25 341 A1 findet sich eine Beleuchtungsvorrichtung insbesondere für medizinische Zwecke.

Diese Aufgabe wird gelöst durch eine Halbleiterlichtquelle mit den Merkmalen des Patentanspruchs 1.

Gemäß zumindest einer Ausführungsform der Halbleiterlichtquelle umfasst diese mindestens zwei Flächenelemente. Die Flächenelemente sind dabei insbesondere separate, einzelne, von einander unabhängig anordenbare und/oder gefertigte Elemente, die bevorzugt eben oder planar ausgestaltet sind. Flächenelement bedeutet insbesondere, dass ein mittlerer Durchmesser größer ist als eine mittlere Dicke des Flächenelements. Insbesondere beträgt der mittlere Durchmesser mindestens ein Zehnfaches, bevorzugt mindestens ein Hundertfaches der mittleren Dicke.

Gemäß zumindest einer Ausführungsform der Halbleiterlichtquelle umfassen die Flächenelemente je ein organisches oder anorganisches Halbleitermaterial zur Erzeugung einer ultravioletten oder einer sichtbaren Strahlung im Betrieb der Halbleiterlichtquelle. Mit anderen Worten sind die Flächenelemente dazu eingerichtet, im Betrieb aktiv sichtbare oder ultraviolette Strahlung zu generieren. Die Flächenelemente sind also im Betrieb der Halbleiterlichtquelle aktive, Strahlung emittierende Elemente.

Gemäß zumindest einer Ausführungsform der Halbleiterlichtquelle emittieren die Flächenelemente die im Betrieb erzeugte Strahlung jeweils an genau einer Hauptfläche. Das heißt, die Flächenelemente können an einer Hauptfläche flächig, insbesondere ganzflächig oder im Wesentlichen ganzflächig abstrahlende Elemente sein.

Gemäß zumindest einer Ausführungsform der Halbleiterlichtquelle beträgt eine Reflektivität der Flächenelemente zumindest außerhalb des Betriebs der Lichtquelle für sichtbare Strahlung mindestens 80 %, insbesondere mindestens 85 %, bevorzugt mindestens 92 %. Die Reflektivität ist hierbei über die gesamte, im Betrieb der Halbleiterlichtquelle Strahlung emittierende Hauptfläche des Flächenelements zu mitteln. Die Reflektivität übersteigt bevorzugt im gesamten sichtbaren Spektralbereich von einschließlich 450 nm bis 780 nm die genannten Werte, mindestens aber über den genannten Spektralbereich hinweg gemittelt. Die Reflektivität ist dabei ein Quotient aus reflektierter Strahlungsleistung und einfallender Strahlungsleistung.

Gemäß zumindest einer Ausführungsform der Halbleiterlichtquelle beträgt ein mittlerer Durchmesser der Flächenelemente jeweils mindestens 10 mm, bevorzugt mindestens 30 mm. Bei zum Beispiel Flächenelementen mit einem quadratischen Grundriss entspricht der mittlere Durchmesser einer Kantenlänge der Flächenelemente, in Draufsicht gesehen. Sind die Flächenelemente beispielsweise rechteckig gestaltet, so beträgt ein Verhältnis aus den Kantenlängen der Längsseite und der Querseite der Flächenelemente bevorzugt höchstens fünf, der mittlere Durchmesser ergibt sich aus einem Mittelwert der Kantenlängen.

Gemäß zumindest einer Ausführungsform der Halbleiterlichtquelle sind die Hauptflächen der Flächenelemente in einem Winkel zueinander angeordnet und einander zugewandt. Der Winkel zwischen den Hauptflächen beträgt hierbei bevorzugt zwischen einschließlich 30° und 120°, insbesondere zwischen einschließlich 45° und 75°, besonders bevorzugt zwischen einschließlich 55° und 65°.

In mindestens einer Ausführungsform der Halbleiterlichtquelle umfasst diese mindestens zwei Flächenelemente. Die Flächenelemente beinhalten jeweils ein Halbleitermaterial zur Erzeugung einer ultravioletten oder sichtbaren Strahlung im Betrieb der Halbleiterlichtquelle. Die Strahlung wird dabei an je genau einer Hauptfläche der Flächenelemente emittiert. Eine Reflektivität der Flächenelemente, außerhalb des Betriebs der Halbleiterlichtquelle, beträgt für sichtbare Strahlung mindestens 80 %. Die Flächenelemente zeigen darüber hinaus einen mittleren Durchmesser von mindestens 10 mm auf. Weiterhin sind die Hauptflächen der Flächenelemente in einem Winkel zueinander angeordnet und einander zugewandt. Der Winkel zwischen den Hauptflächen beträgt dabei zwischen einschließlich 30° und 120°.

Gemäß zumindest einer Ausführungsform der Halbleiterlichtquelle trifft ein Teil der von der Hauptfläche von einem ersten der Flächenelemente emittierten Strahlung auf die Hauptfläche eines zweiten der Flächenelemente, die der Hauptfläche des ersten Flächenelements zugewandt ist. An der Hauptfläche des zweiten Flächenelements erfolgt bevorzugt eine genau einmalige Reflexion und nachfolgend eine Auskopplung des betreffenden Teils der Strahlung aus der Halbleiterlichtquelle. Mit anderen Worten bildet das zweite Flächenelement einen Spiegel für einen Teil der Strahlung, die vom ersten Flächenelement emittiert wird und umgekehrt.

Dadurch, dass die Flächenelemente insbesondere gegenseitig die emittierte Strahlung wenigstens teilweise reflektieren, und durch die zueinander abgewinkelte Anordnung ist eine Abstrahlcharakteristik der Halbleiterlichtquelle einstellbar. Beispielsweise wird ein Raumwinkelbereich bezüglich mindestens einer Raumrichtung, in dem die Strahlung emittiert wird, desto kleiner, je kleiner der Winkel zwischen den Hauptflächen der Flächenelemente bezüglich dieser Raumrichtung ist.

Gemäß zumindest einer Ausführungsform der Halbleiterlichtquelle folgt eine Abstrahlcharakteristik mindestens eines der Flächenelemente oder aller Flächenelement dem folgenden Zusammenhang:

$$I\ (\beta)\ =\ I_{max}\ \cos(\beta).$$

$I_{max}$ ist hierbei eine maximale Strahlungsintensität, die von dem Flächenelement in eine bestimmte Richtung emittiert wird, insbesondere in eine Richtung parallel zu einem Lot der Hauptfläche des Flächenelements. $\beta$ ist ein Winkel zu dem Lot der Hauptfläche und I ist eine Strahlungsintensität des Flächenelements entlang der Richtung, die durch den Winkel $\beta$ definiert ist. Die Abstrahlcharakteristik folgt dem angegebenen Zusammenhang bevorzugt mit einer Toleranz von höchstens 0,1 $I_{max}$ oder höchstens 0,1 $I_{max}$, insbesondere mit einer Toleranz von höchstens 0,05 $I_{max}$, bevorzugt von höchstens 0,02 $I_{max}$. Mit anderen Worten gilt I ($\beta$) = $I_{max}$ ($\cos(\beta) \pm$ T), wobei T = 0,2 oder 0,1 oder 0,05 oder 0,02.

Gemäß zumindest einer Ausführungsform der Halbleiterlichtquelle beträgt ein Abstand zwischen zwei benachbarten Flächenelementen, in einer Richtung senkrecht zu einer Winkelhalbierenden bezüglich des Winkels $\alpha$ zwischen den einander zugewandten Hauptflächen der Flächenelemente, zwischen dem einschließlich 0,15-fachen und 0,35-fachen oder zwischen einschließlich dem 1,75-fachen und 2,25-fachen des mittleren Durchmessers der Flächenelemente. Mit anderen Worten sind die Flächenelemente in einer lateralen Richtung voneinander beabstandet. Der Abstand ist hierbei entweder vergleichsweise klein oder, jeweils bezogen auf den mittleren Durchmesser der Flächenelemente, vergleichsweise groß.

Gemäß zumindest einer Ausführungsform der Halbleiterlichtquelle weist die Abstrahlcharakteristik wenigstens ein Intensitätsmaximum in einem Winkelbereich zwischen einschließlich 25° und 70°, insbesondere zwischen einschließlich 50° und 65° auf. Der Winkel ist hierbei bezogen auf die Winkelhalbierende zwischen den einander zugewandten Hauptflächen der Flächenelemente. Mit anderen Worten wird eine maximale Intensität, bezogen auf einen Abstrahlwinkel, nicht in eine Richtung senkrecht zu einer Haupterstreckungsrichtung der Halbleiterlichtquelle und/oder der Flächenelemente emittiert, sondern in eine davon abweichende Richtung.

Gemäß zumindest einer Ausführungsform der Halbleiterlichtquelle beträgt ein Strahlungsanteil der im Betrieb von der Halbleiterlichtquelle erzeugten Strahlung, der in einen der Hauptflächen abgewandten Halbraum emittiert wird, zwischen einschließlich 20 % und 40 %, insbesondere zwischen einschließlich 30 % und 40 %. Der Halbraum ist hierbei insbesondere durch einen Raumwinkelbereich zwischen 90° und einschließlich 180°, bezogen zum Beispiel auf die Winkelhalbierende zwischen den einander zugewandten Hauptflächen der Flächenelemente, gebildet.

Gemäß zumindest einer Ausführungsform der Halbleiterlichtquelle ist deren Abstrahlcharakteristik nicht rotationssymmetrisch. Insbesondere weist die Abstrahlcharakteristik, in Draufsicht auf die Halbleiterlichtquelle gesehen, genau eine oder genau zwei Symmetrieachsen auf. Beispielsweise wird die von der Halbleiterlichtquelle erzeugte Strahlung, in Draufsicht auf die Halbleiterlichtquelle gesehen, in zwei senkrecht zueinander stehenden Richtungen unterschiedlich stark aufgeweitet. Das heißt, Halbwertwinkel der Abstrahlcharakteristik entlang insbesondere der zwei Symmetrieachsen oder entlang der einen Symmetrieachse und einer Richtung senkrecht zu dieser Symmetrieachse, sind voneinander verschieden.

Hierbei ist der Halbwertwinkel insbesondere jeweils derjenige Winkel, bei dem eine Strahlungsintensität, bezogen auf eine maximale Strahlungsintensität beziehungsweise auf einen maximalen Lichtstrom in einer bestimmten Richtung, auf die Hälfte abgesunken ist.

Gemäß zumindest einer Ausführungsform der Halbleiterlichtquelle umfassen die Flächenelemente jeweils organische Leuchtdioden. Die Hauptflächen der jeweiligen Flächenelemente sind durch die organischen Leuchtdioden bevorzugt jeweils zu mindestens 50 %, insbesondere zu mindestens 80 % oder zu mindestens 90 % bedeckt. Mit anderen Worten ist bevorzugt die gesamte oder im Wesentlichen die gesamte Hauptfläche der Flächenelemente von der organischen Leuchtdiode bedeckt.

Gemäß zumindest einer Ausführungsform der Halbleiterlichtquelle ist eines der Flächenelemente oder sind alle Flächenelemente organische Leuchtdioden.

Gemäß zumindest einer Ausführungsform der Halbleiterlichtquelle umfasst eines der Flächenelemente oder umfassen alle Flächenelemente mindestens vier anorganische optoelektronische Halbleiterchips, insbesondere mindestens sechs optoelektronische Halbleiterchips, bevorzugt mindestens zehn optoelektronische Halbleiterchips. Ein Anteil an der Hauptfläche des jeweiligen Flächenelements, der von den Halbleiterchips bedeckt ist, beträgt insbesondere je höchstens 5 %, bevorzugt jeweils höchstens 3 %. Mit anderen Worten kann die Hauptfläche von den Halbleiterchips im Wesentlichen unbedeckt sein.

Gemäß zumindest einer Ausführungsform der Halbleiterlichtquelle reflektieren die Flächenelemente sichtbare Strahlung mindestens teilweise derart, dass ein Einfallswinkel der Strahlung gleich einem Ausfallswinkel der Strahlung ist. Mit anderen Worten reflektieren die Flächenelemente nicht diffus.

Gemäß zumindest einer Ausführungsform der Halbleiterlichtquelle weisen die Flächenelemente, in Draufsicht auf die Halbleiterlichtquelle gesehen, voneinander verschiedene Flächeninhalte auf. Mit anderen Worten zeigen in einer Projektion auf eine Ebene, insbesondere definiert durch eine Haupterstreckungsebene und/oder durch eine Ebene senkrecht zu einer Hauptabstrahlrichtung der Halbleiterlichtquelle, die Flächenelemente ungleiche Flächen auf. Es können die Hauptflächen der Flächenelemente hierbei gleiche Flächeninhalte aufzeigen, in Draufsicht auf die jeweilige Hauptflächen gesehen. Mit anderen Worten können die Flächenelemente unterschiedliche, voneinander verschiedene Orientierungen zu der Haupterstreckungsebene und/oder der Hauptabstrahlrichtung aufweisen.

Gemäß zumindest einer Ausführungsform der Halbleiterlichtquelle sind die Flächenelemente strahlungsundurchlässig für sichtbare Strahlung und für ultraviolette Strahlung. Das heißt, die Flächenelemente sind weder transparent noch transluzent.

Nachfolgend wird eine hier beschriebene Halbleiterlichtquelle unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

Figuren 1, 4 und 6 bis 11   schematische Darstellungen von Ausführungsbeispielen von hier beschriebenen Halbleiterlichtquellen, und

Figuren 2, 3 und 5   schematische Darstellungen von Abstrahlcharakteristiken von hier beschriebenen Halbleiterlichtquellen.

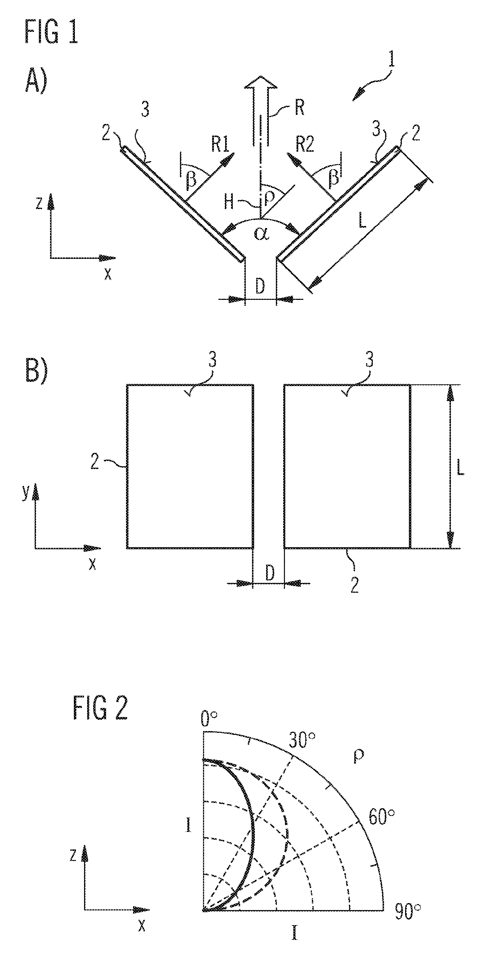

In Figur 1 ist ein Ausführungsbeispiel einer Halbleiterlichtquelle 1 dargestellt. Die Halbleiterlichtquelle 1 beinhaltet zwei Flächenelemente 2. Jedes der Flächenelemente 2 weist eine Hauptfläche 3 auf, über die im Betrieb der Halbleiterlichtquelle 1 eine elektromagnetische Strahlung R im sichtbaren und/oder ultravioletten Spektralbereich emittiert wird.

Die Hauptflächen 3 der Flächenelemente 2 weisen weiterhin eine Reflektivität für sichtbare Strahlung, gemittelt über die gesamten Hauptflächen 3, auf, die bevorzugt mindestens 95 % beträgt. Die Flächenelemente 2 sind für sichtbare Strahlung undurchlässig. Die Hauptflächen 3 der Halbleiterlichtquelle 1 wirken also wenigstens außerhalb des Betriebs der Halbleiterlichtquelle 1 als spiegelnde Flächen. Zum Beispiel weisen die Flächenelemente 2 jeweils einen Träger aus einem Glas auf, der an einer Hauptfläche mit einem Metall beschichtet ist.

Ferner sind die Flächenelemente 2 bevorzugt Flächenstrahler und/oder Lambert'sche Strahler. Das kann heißen, eine richtungsabhängige Strahlungsintensität $I(\beta)$ folgt näherungsweise dem Zusammenhang $I(\beta) = I_{max} \cos(\beta)$. Der Winkel $\beta$ bezieht sich jeweils auf ein Lot zu den Hauptflächen 3.

Die beiden Hauptflächen 3 der Flächenelemente 2, an der die Strahlung im Betrieb der Halbleiterlichtquelle 1 emittiert wird, sind jeweils planar gestaltet, in einem Winkel $\alpha$ relativ zueinander angeordnet und weisen einen Abstand D in einer lateralen Richtung x voneinander auf, vergleiche die Seitenansicht in Figur 1A und die Draufsicht in Figur 1B. Die gleich großen Flächenelemente 2 weisen näherungsweise einen quadratischen Grundriss mit einer Kantenlänge L auf, wobei die Kantenlänge L einem mittleren Durchmesser der Flächenelemente 2 entspricht. In Draufsicht, siehe Figur 1B, erscheinen die im Grundriss quadratischen Flächenelemente 2 allerdings als Rechtecke.

Dadurch, dass die Hauptflächen 3 der Flächenelemente 2 reflektierend wirken und zueinander gewinkelt angeordnet sind, trifft ein Teil der von den Flächenelementen 2 emittierten Strahlung R1, R2 auf das jeweils andere, gegenüberliegende Flächenelement 2. Über einmalige Reflexion an dem jeweils anderen Flächenelement 2 und nachfolgender Strahlungsauskopplung aus der Halbleiterlichtquelle 1 erfolgt eine Formung einer Abstrahlcharakteristik der von der Halbleiterlichtquelle 1 emittierten Strahlung R. Ein Intensitätsmaximum wird in einer Richtung z einer Winkelhalbierenden H des Winkels $\alpha$ zwischen den Hauptflächen 3 emittiert.

Der Winkel $\alpha$ beträgt zwischen einschließlich 30° und 120°, bevorzugt zwischen einschließlich 55° und 65°. Abweichend hiervon beträgt der Winkel $\alpha$ bei den Ausführungsbeispielen gemäß der Figuren 1 und 2 zirka 90°. Der Abstand D zwischen den Flächenelementen 2 beträgt zirka ein 0,15-faches der Kantenlänge L. Über die Beabstandung der Flächenelemente 2 kann ein Teil der von den Flächenelementen 2 im Betrieb der Halbleiterlichtquelle 1 erzeugten Strahlung R in einen der Hauptflächen 3 abgewandten Halbraum gelangen. Wird die Halbleiterlichtquelle 1 beispielsweise als Deckenleuchte eingesetzt, so dass ein Großteil der Strahlung R weg von der Decke emittiert wird, gelangt doch ein kleiner Strahlungsanteil hin zu der Decke. Hierdurch ist die Beleuchtung durch die Halbleiterlichtquelle 1 von einem Betrachter als angenehmer empfindbar.

Die Abstrahlcharakteristik der Halbleiterlichtquelle 1 ist in Figur 2 illustriert. Aufgetragen ist die richtungsabhängige Intensität I in Abhängigkeit von dem Winkel $\rho$ relativ zur Winkelhalbierenden H, siehe die durchgezogene Linie. Im Vergleich zu einer Lambert'schen Abstrahlcharakteristik der Flächenelemente 2, vergleiche die Strich-Linie, ist die Strahlung deutlich stärker in eine Vorwärtsrichtung beziehungsweise in eine z-Richtung gelenkt. Mit anderen Worten ist ein Öffnungswinkel oder ein Halbwertwinkel einer Abstrahlung der Halbleiterlichtquelle 1, im Vergleich zu einem Lambert'schen Strahler, deutlich verringert.

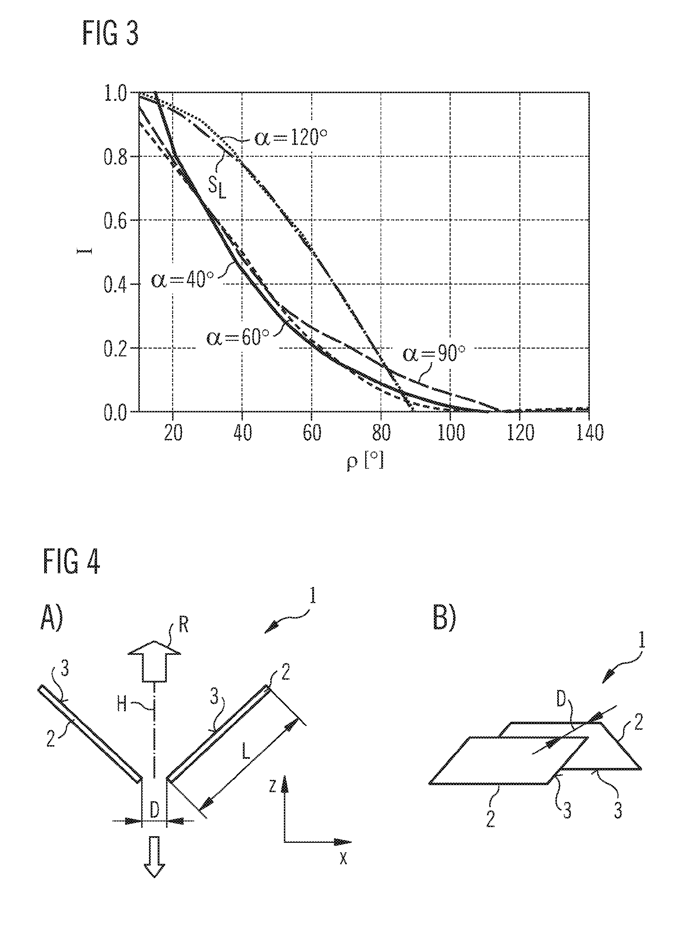

In Figur 3 ist die winkelabhängige Abstrahlintensität I in Abhängigkeit von dem Winkel $\rho$ für verschiedene Halbleiterlichtquellen 1 mit verschiedenen Winkeln $\alpha$ zwischen den Hauptflächen 3 der Flächenelemente 2 dargestellt. Als Vergleich ist zusätzlich die Abstrahlcharakteristik eines Lambert'schen Strahlers, siehe die mit $S_L$ gekennzeichnete Kurve, eingetragen. Da die Flächenelemente 2 in lateraler Richtung einen von Null verschiedenen Abstand D mit D $\leq$ 0,15 x L zueinander aufweisen, wird auch ein kleiner Strahlungsanteil in den Halbraum emittiert, der den Hauptflächen 3 abgewandt ist. Dieser Halbraum weist einen Winkelbereich, bezogen auf die Winkelhalbierende H, von 90° bis einschließlich 180° auf.

Für große Öffnungswinkel zwischen den einander zugewandten Hauptflächen 3, beispielsweise $\alpha$ = 120°, nähert sich die Abstrahlcharakteristik der eines Lambert'schen Strahlers an. Für kleine Öffnungswinkel, beispielsweise $\alpha$ = 40° oder $\alpha$ = 60°, ist die Abstrahlung konzentriert auf kleine Winkel $\rho$. Für einen Öffnungswinkel von $\alpha$ = 90° wird bereits ein signifikant größerer Anteil der Strahlung R in einen Winkelbereich mit 60° < $\rho$ < 80° emittiert, im Vergleich zu einem Lambert'schen Strahler.

Für die Winkel $\alpha$ = 40°, $\alpha$ = 60°, $\alpha$ = 90° und $\alpha$ = 120° betragen die Halbwertwinkel $\theta_{50}$ dann 35°, 38°, 42° beziehungsweise 45°. Die Halbwertwinkel $\theta_{50}$ entsprechen den Winkeln, innerhalb derer 50 % des Lichtstroms emittiert werden.

Bei der Halbleiterlichtquelle 1 gemäß Figur 4, siehe die Seitenansicht gemäß Figur 4A und die dreidimensionale Darstellung gemäß Figur 4B, ist der Abstand D zwischen den Flächenelementen 2 vergrößert. Dadurch wird ein signifikanter Strahlungsanteil R3, bezogen auf die in z-Richtung emittierte Strahlung R, in den Hauptflächen 3 abgewandten Halbraum emittiert. Das Intensitätsverhältnis der Strahlungen R, R3 ist durch eine Breite der die Strahlungen R, R3 symbolisierenden Pfeile angedeutet.

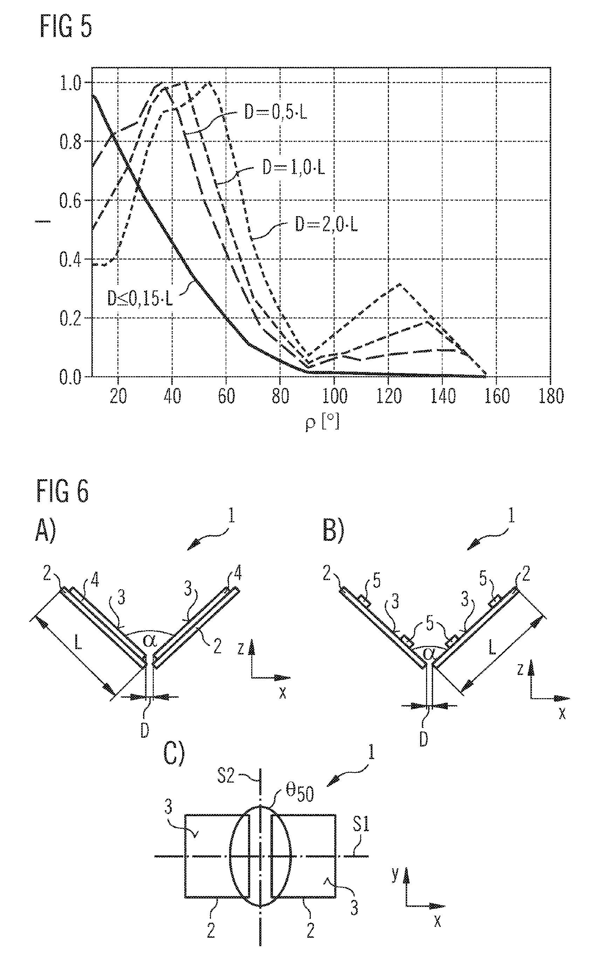

In Figur 5 ist für verschiedene Halbleiterlichtquellen 1 die winkelabhängige Intensität I der Strahlung R entlang des Abstrahlwinkels $\rho$ für verschiedene Abstände D zwischen den Flächenelementen 2 dargestellt. Der Winkel $\alpha$ zwischen den Flächenelementen 2 beträgt hierbei jeweils zirka 60°. Es sind die winkelabhängigen Strahlungsintensitäten I dargestellt für den Fall D $\leq$ 0,15 x L, D = 0,5 x L, D = 1,0 x L und D = 2,0 x L. Für den Fall D $\leq$ 0,15 x L entspricht die Kurve näherungsweise der aus Figur 3 für $\alpha$ = 60°. Letztgenannte Kurve ist als Vergleich eingetragen für den Fall, dass der Abstand D zwischen den Flächenelementen 2 vergleichsweise gering ist. Der Anteil der Strahlung R3, gemessen an der von der Halbleiterlichtquelle 1 im Betrieb erzeugten Strahlung und in z-Richtung abgestrahlten Strahlung R, der in den den Hauptflächen 3 abgewandten Halbraum emittiert wird, beträgt zirka 19 % für D = 0,5 x L, zirka 27 % für D = 1,0 x L und zirka 36 % für D = 2,0 x L.

Für größere relative Abstände D zwischen den Flächenelementen 2, also insbesondere für D = 1,0 x L und D = 2,0 x L, weist die winkelabhängige Strahlungsintensität I ein Maximum bei Winkeln $\rho$ zwischen einschließlich zirka 35° und 65° auf. Mit zunehmendem Abstand D wird auch ein größerer Strahlungsanteil in den Hauptflächen 2 abgewandten Halbraum mit Winkeln 90° < $\rho$ $\leq$ 180° emittiert.

Gemäß Figur 6A umfassen die Flächenelemente 2 jeweils organische Leuchtdioden 4. Die organischen Leuchtdioden 4 bedecken im Wesentlichen jeweils die gesamten Hauptflächen 3 der zugehörigen Flächenelemente 2. Die hohe Reflektivität der Flächenelemente 2 außerhalb des Betriebs der Halbleiterlichtquelle 1 rührt insbesondere von einer reflektierend gestalteten flächigen Elektrode der organischen Leuchtdioden 4 her. Ebenso ist es möglich, dass jedes der Flächenelemente 2 durch eine organische Leuchtdioden gebildet ist.

Gemäß Figur 6B weisen die Flächenelemente jeweils mindestens vier optoelektronische anorganische Halbleiterchips 5 auf, die nur einen kleinen Flächenanteil der Hauptfläche 3 bedecken. Jedes der Flächenelemente 2 kann, auch wenn näherungsweise Punktlichtquellen in Form der Halbleiterchips 5 eingesetzt werden, insgesamt betrachtet ein Lambert'sches Abstrahlprofil aufweisen.

Der mittlere Durchmesser L der Flächenelemente 2 beträgt beispielsweise je zwischen 1 cm und 100 cm, insbesondere zwischen 3 cm und 30 cm, wie auch in allen anderen Ausführungsbeispielen. Die Hauptflächen 3 sind nicht diffus reflektiv, sondern bei Reflexion mindestens eines überwiegenden Teils der Strahlung findet das Reflexionsgesetz Anwendung, so dass ein Ausfallswinkel einer reflektierten Strahlung gleich derem Einfallswinkel ist.

Zu Figur 6C ist die Abstrahlcharakteristik anhand des Halbwertwinkels $\theta_{50}$ in Draufsicht auf die Halbleiterlichtquelle 1 illustriert. Die Abstrahlcharakteristik weist zwei Symmetrieachsen S1, S2 auf, die zu einander orthogonal orientiert sind. Entlang der Symmetrieachse S1, also entlang der y-Richtung, ist der Halbwertwinkel $\theta_{50}$ kleiner als entlang der Symmetrieachse S2 in y-Richtung. Es erfolgt also eine Strahlbündelung entlang der x-Richtung, wohingegen entlang der y-Richtung näherungsweise keine Strahlbündelung erfolgt.

Die Strahlformung beziehungsweise Strahlbündelung erfolgt insbesondere, wie auch in allen anderen Ausführungsbeispielen, ohne den Einsatz von Linsen oder gekrümmten Reflektoren. Die Strahlformung kann also einzig durch Reflexion an den bevorzugt planaren, vergleichsweise großflächigen Hauptflächen 3 erzielt werden. Das heißt, die Halbleiterlichtquelle 1 kann frei von zusätzlichen, optisch diffraktiv oder refraktiv wirkenden, strahlformenden Elementen sein.

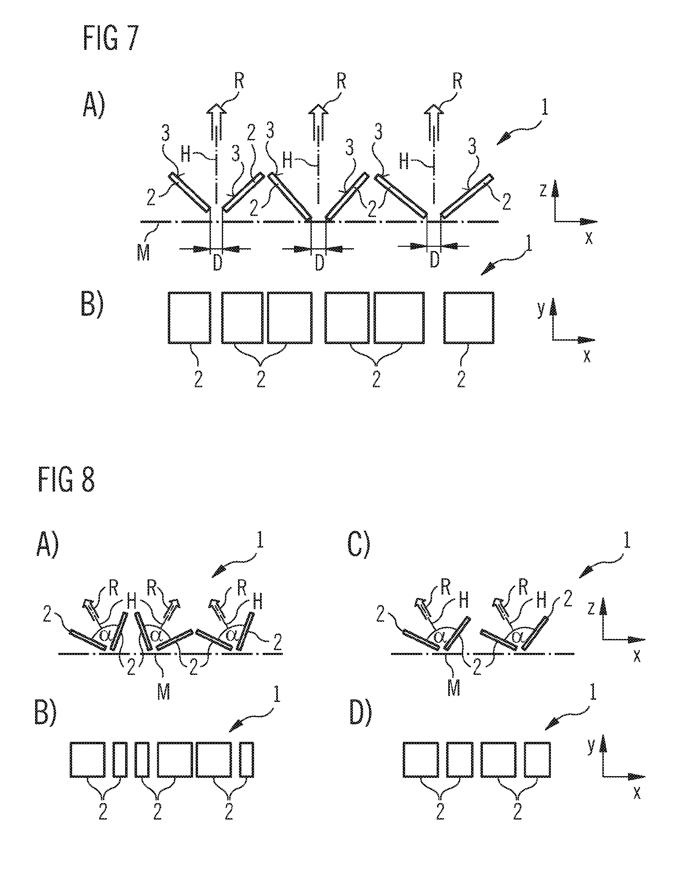

In Figur 7 ist ein Ausführungsbeispiel der Halbleiterlichtquelle 1 gezeigt, bei der die Halbleiterlichtquelle 1 eine Vielzahl von Flächenelementen 2 aufweist. Jeweils zwei der Hauptflächen 3 der Flächenelemente 2 sind paarweise einander zugewandt. In Seitenansicht, vergleiche Figur 7A, weist die Halbleiterlichtquelle 1 eine sägezahnartige Form auf. Mit anderen Worten sind die Flächenelemente 2 dachartig angeordnet. Alle Flächenelemente 2 schließen entlang der y-Richtung bündig mit der Montagefläche M ab.

Die Strahlung R wird im Wesentlichen weg von einer Montagefläche M emittiert, an der die einzelnen Flächenelemente 2 angebracht sein können. An der Montagefläche M weisen die Flächenelemente 2 den Abstand D zueinander auf, an der Montageflächen M abgewandten Randbereiche der Flächenelemente 2 können sich die Flächenelemente 2 jeweils, anders als in Figur 7 dargestellt, berühren. Abweichend von der Darstellung in Figur 7 ist es wie auch bei allen anderen Ausführungsbeispielen möglich, dass der Abstand D gleich Null ist, sich die Flächenelemente 2 also zum Beispiel paarweise berühren.

Beim Ausführungsbeispiel gemäß Figur 8 weisen die Flächenelemente 2 in Draufsicht beziehungsweise in Projektion auf die Montagefläche M gesehen, siehe die Figuren 8B und 8D, paarweise unterschiedliche Flächeninhalte auf. Jedoch sind die Flächenelemente 2, vergleiche die Seitenansicht in Figur 8A und in Figur 8C, gleich groß gestaltet. Die Winkelhalbierenden H der Paare von Flächenelementen 2 weisen jeweils einen Winkel ungleich 90° zu der Montagefläche M auf. Gemäß Figur 8A weisen die Winkelhalbierenden H in unterschiedliche Richtungen, gemäß Figur 8C weisen alle Winkelhalbierenden H in dieselbe Richtung, wie auch beim Ausführungsbeispiel gemäß Figur 7.

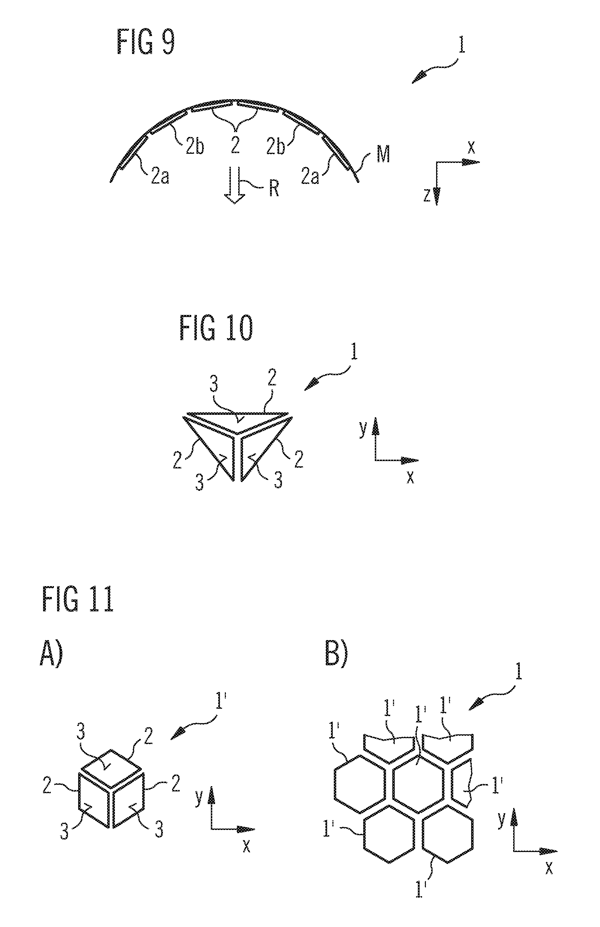

In Figur 9 ist eine Schnittdarstellung eines weiteren Ausführungsbeispiels der Halbleiterlichtquelle 1 gezeichnet. Die Paare von Flächenelementen 2a, 2b sind räumlich durch andere Flächenelemente 2 voneinander getrennt. Die Montagefläche M weist eine halbkugelartige, sphärische Form auf. Bei diesem Ausführungsbeispiel sind im Wesentlichen nur die Flächenelemente 2a, 2b in einem Winkel zueinander angeordnet. Die Flächenelemente 2, 2a, 2b sind jeweils planar beziehungsweise eben geformt.

Beim Ausführungsbeispiel gemäß Figur 10 sind die Flächenelemente 2 als gleichseitige Dreiecke gestaltet, die ähnlich einer tetraedrischen Pyramide ohne Bodenfläche angeordnet sind. Die Flächenelemente 2 sind jeweils voneinander beabstandet. Es ist möglich, dass mehrere der Halbleiterlichtquellen 1 gemäß Figur 10 lateral benachbart angeordnet sind und eine größere, zusammen gesetzte Lichtquelle bilden.

Im Ausführungsbeispiel gemäß Figur 10 weisen die Flächenelemente 2 jeweils einen quadratischen Grundriss auf und sind ähnlich einem Retroreflektor würfelartig angeordnet, vergleiche die Draufsicht in Figur 11A. In Figur 11B sind mehrere der Halbleiterlichtquellen 1' gemäß Figur 11A zu einer Halbleiterlichtquelle 1 zusammengesetzt. Weiterhin ist es hierbei möglich, dass einzelne der Halbleiterlichtquellen 1' eine maximale Strahlungsintensität in voneinander verschiedene Winkel emittieren, anders als in Figur 10 illustriert.

## Patentansprüche

1.   Halbleiterlichtquelle (1) mit mindestens zwei Flächenelementen (2), wobei

- die Flächenelemente (2) je ein Halbleitermaterial (4) zur Erzeugung einer ultravioletten oder sichtbaren Strahlung (R) im Betrieb der Halbleiterlichtquelle (1) umfassen, wobei die Strahlung (R) an je genau einer Hauptfläche (3) der Flächenelemente (2) emittiert wird,
- eine Reflektivität der Flächenelemente (2) außerhalb des Betriebs der Halbleiterlichtquelle (1) für sichtbare Strahlung mindestens 80 % beträgt,
- die Hauptflächen (3) in einem Winkel (a) zueinander angeordnet und einander zugewandt sind, und
- der Winkel (a) zwischen den Hauptflächen (3) zwischen einschließlich 30° und 120° beträgtflächen (3) zwischen einschließlich 30° und 120° beträgtflächen (3) zwischen einschließlich 30° und 120° beträgt, und
- ein mittlerer Durchmesser (L) der Flächenelemente (2) mindestens 10 mm beträgt, und
- ein Abstand (D) zwischen zwei benachbarten Flächenelementen (2), in einer Richtung senkrecht zu einer Winkelhalbierenden (H) des Winkels (a), zwischen dem einschließlich 0,15fachen und 0,35fachen oder zwischen dem einschließlich 1,75fachen und 2,25fachen des mittleren Durchmessers (L) beträgt,

**dadurch gekennzeichnet, dass**
ein Strahlungsanteil zwischen einschließlich 20 % und 40 % der im Betrieb erzeugten Strahlung (R) in einen den Hauptflächen (3) abgewandten Halbraum emittiert wird.

2.   Halbleiterlichtquelle (1) nach dem vorhergehenden Anspruch, bei der die Flächenelemente (2) organische Leuchtdioden (4) umfassen, die je mindestens 50 % der Hauptfläche (3) des zugehörigen Flächenelements (2) bedecken.

3.   Halbleiterlichtquelle (1) nach einem der vorhergehenden Ansprüche,

bei der ein Teil der von der Hauptfläche (3) von einem ersten der Flächenelemente (2) emittierten Strahlung (R) genau einmal an der dieser Hauptfläche (3) zugewandten Hauptfläche (3) eines zweiten der Flächenelemente (3) reflektiert wird, und nachfolgend eine Auskopplung dieses Teils der Strahlung (R) aus der Halbleiterlichtquelle (1) erfolgt.

4. Halbleiterlichtquelle (1) nach einem der vorhergehenden Ansprüche,
bei der der mittlere Durchmesser (L) der Flächenelemente (2) je zwischen 3 cm und 30 cm beträgt.

5. Halbleiterlichtquelle (1) nach einem der vorhergehenden Ansprüche,
deren Abstrahlcharakteristik wenigstens ein Intensitätsmaximum in einem Winkelbereich zwischen einschließlich 25° und 70° aufzeigt, bezogen auf einen Abstrahlwinkel relativ zu der Winkelhalbierenden (H).

6. Halbleiterlichtquelle (1) nach einem der vorhergehenden Ansprüche,
bei der ein Strahlungsanteil zwischen einschließlich 30 % und 40 % der im Betrieb erzeugten Strahlung (R) in einen den Hauptflächen (3) abgewandten Halbraum emittiert wird.

7. Halbleiterlichtquelle (1) nach einem der vorhergehenden Ansprüche,
bei der eine Abstrahlcharakteristik, in Draufsicht auf die Halbleiterlichtquelle (1) gesehen, eine oder zwei Symmetrieachsen (S) aufweist,
wobei Halbwertwinkel ($\theta_{50}$) der Abstrahlcharakteristik entlang der zwei Symmetrieachsen (S), oder entlang der einen Symmetrieachse (S) und einer Richtung senkrecht dazu, voneinander verschieden sind,
und wobei die Halbwertwinkel ($\theta_{50}$) diejenigen Winkel sind, bei denen eine Strahlungsintensität, bezogen auf eine maximale Strahlungsintensität, auf die Hälfte abgesunken ist.

8. Halbleiterlichtquelle (1) nach einem der vorhergehenden Ansprüche,
bei der eine Abstrahlcharakteristik der Flächenelemente (2), mit einer Toleranz von höchstens 0,1 $I_{max}$, dem Zusammenhang folgt:

$$I(\beta) = I_{max} \cos(\beta),$$

wobei $I_{max}$ eine maximale richtungsbezogene Strahlungsintensität, $\beta$ ein Winkel zu einem Lot des zugehörigen Flächenelements (2) und I eine Strahlungsintensität des zugehörigen Flächenelements (2) entlang einer durch den Winkel $\beta$ definierten Richtung ist.

9. Halbleiterlichtquelle (1) nach einem der vorhergehenden Ansprüche,
bei der die Flächenelemente (2) je mindestens vier anorganische optoelektronische Halbleiterchips (5) umfassen, die insgesamt je höchstens 5 % der Hauptfläche (3) des zugehörigen Flächenelements (2) bedecken.

10. Halbleiterlichtquelle (1) nach einem der vorhergehenden Ansprüche,
bei der die Flächenelemente (2) jeweils sichtbare Strahlung mindestens teilweise derart reflektieren, dass ein Einfallswinkel der Strahlung (R) gleich einem Ausfallswinkel ist.

11. Halbleiterlichtquelle (1) nach einem der vorhergehenden Ansprüche,
bei der die Flächenelemente (2) pyramidenartig, halbkugelartig, dachartig und/oder würfelartig angeordnet sind.

12. Halbleiterlichtquelle (1) nach einem der vorhergehenden Ansprüche,
die eine Vielzahl von Flächenelementen (2) umfasst, wobei die Flächenelemente (2) sägezahnartig angeordnet sind, im Querschnitt gesehen.

13. Halbleiterlichtquelle (1) nach einem der vorhergehenden Ansprüche,
bei der die Flächenelemente (2), in Draufsicht auf die Halbleiterlichtquelle (1) gesehen, voneinander verschiedene Flächeninhalte aufzeigen.

14. Halbleiterlichtquelle (1) nach einem der vorhergehenden Ansprüche,
bei der die Flächenelemente (2) strahlungsundurchlässig sind.

**Claims**

1. Semiconductor light source (1) comprising at least two surface elements (2) wherein

   - the surface elements (2) each comprise a semiconductor material (4) for generating ultraviolet or visible radiation (R) during the operation of the semiconductor light source (1), wherein the radiation (R) is emitted at in each case exactly one main surface (3) of the surface elements (2),
   - a reflectivity of the surface elements (2) outside the operation of the semiconductor light source (1) for visible radiation is at least 80%,
   - the main surfaces (3) are arranged at an angle (a) with respect to one another and face one another, and
   - the angle (a) between the main surfaces (3) is between 30° and 120° inclusive, and
   - an average diameter (L) of the surface elements (2) is at least 10 mm, and
   - a distance (D) between two adjacent surface elements (2), in a direction perpendicular to an angle bisector (H) of the angle (a), is between 0.15 times and 0.35 times the average diameter (L) inclusive or between 1.75 times and 2.25 times the average diameter (L) inclusive, **characterized in that**

   a radiation proportion of between 20% and 40% inclusive of the radiation (R) generated during operation is emitted into a half-space facing away from the main surfaces (3).

2. Semiconductor light source (1) according to the preceding claim, wherein the surface elements (2) comprise organic light-emitting diodes (4) which each cover at least 50% of the main surface (3) of the associated surface element (2).

3. Semiconductor light source (1) according to either of the preceding claims, wherein part of the radiation (R) emitted from the main surface (3) from a first of the surface elements (2) is reflected exactly once at the main surface (3) of a second of the surface elements (3), the latter main surface facing the former main surface (3), and said part of the radiation (R) is subsequently coupled out from the semiconductor light source (1).

4. Semiconductor light source (1) according to any of the preceding claims, wherein the average diameter (L) of the surface elements (2) is in each case between 3 cm and 30 cm.

5. Semiconductor light source (1) according to any of the preceding claims, the emission characteristic of which has at least one intensity maximum in an angle range of between 25° and 70° inclusive, in relation to an emission angle relative to the angle bisector (H).

6. Semiconductor light source (1) according to any of the preceding claims, wherein a radiation proportion of between 30% and 40% inclusive of the radiation (R) generated during operation is emitted into a half-space facing away from the main surfaces (3).

7. Semiconductor light source (1) according to any of the preceding claims, wherein an emission characteristic, as seen in plan view of the semiconductor light source (1), has one or two axes (S) of symmetry, wherein half-value angles ($\theta_{50}$) of the emission characteristic along the two axes (S) of symmetry, or along one axis (S) of symmetry and a direction perpendicular thereto, differ from one another, and wherein the half-value angles ($\theta_{50}$) are those angles at which a radiation intensity has fallen to half, in relation to a maximum radiation intensity.

8. Semiconductor light source (1) according to any of the preceding claims, wherein an emission characteristic of the surface elements (2) with a tolerance of at most 0.1 $I_{max}$ follows the relationship:

$$I(\beta) = I_{max} \cos(\beta),$$

wherein $I_{max}$ is a maximum direction-related radiation intensity, $\beta$ is an angle with respect to a perpendicular of the associated surface element (2) and I is a radiation intensity of the associated surface element (2) along a direction defined by the angle $\beta$.

9. Semiconductor light source (1) according to any of the preceding claims,
wherein the surface elements (2) each comprise at least four inorganic optoelectronic semiconductor chips (5) which overall each cover at most 5% of the main surface (3) of the associated surface element (2).

10. Semiconductor light source (1) according to any of the preceding claims,
wherein the surface elements (2) in each case at least partly reflect visible radiation in such a way that an angle of incidence of the radiation (R) is equal to an angle of reflection.

11. Semiconductor light source (1) according to any of the preceding claims,
wherein the surface elements (2) are arranged in a pyramid-like, hemisphere-like, roof-like and/or cube-like fashion.

12. Semiconductor light source (1) according to any of the preceding claims,
which comprises a multiplicity of surface elements (2) wherein the surface elements (2) are arranged in a saw tooth-like fashion, as seen in cross section.

13. Semiconductor light source (1) according to any of the preceding claims,
wherein the surface elements (2) exhibit mutually different surface areas, as seen in a plan view of the semiconductor light source (1).

14. Semiconductor light source (1) according to any of the preceding claims,
wherein the surface elements (2) are radiation-nontransmissive.

**Revendications**

1. Source lumineuse à semi-conducteur (1) comportant au moins deux éléments de surface (2), dans laquelle

- les éléments de surface (2) comprennent chacun un matériau semi-conducteur (4) destiné à générer un rayonnement ultraviolet ou visible (R) lors du fonctionnement de la source lumineuse à semi-conducteur (1), dans laquelle le rayonnement (R) est émis précisément sur une surface principale (3) des éléments de surface (2),
- une réflectivité des éléments de surface (2), en dehors du fonctionnement de la source lumineuse à semi-conducteur (1) est d'au moins 80 % pour un rayonnement visible,
- les surfaces principales (3) sont agencées selon un angle (a) les unes par rapport aux autres et sont tournées les unes vers les autres, et
- l'angle (a) entre les surface principales (3) est compris entre 30° inclus et 120°, et
- un diamètre moyen (L) des éléments de surface (2) est d'au moins 10 mm, et
- une distance (D) entre deux éléments de surface voisins (2), dans une direction perpendiculaire à une bissectrice (H) de l'angle (a), est comprise entre 0,15 fois inclus et 0,35 fois ou entre 1,75 fois inclus et 2,25 fois le diamètre moyen (L),

**caractérisée en ce qu'**une partie du rayonnement comprise entre 20 % et 40 % du rayonnement (R) généré lors du fonctionnement est émise dans un demi-espace tourné à l'opposé de l'une des surfaces principales (3).

2. Source lumineuse à semi-conducteur (1) selon la revendication précédente, dans laquelle les éléments de surface (2) comprennent des diodes électroluminescentes organiques (4) qui recouvrent chacune au moins 50 % de la surface principale (3) de l'élément de surface correspondant (2).

3. Source lumineuse à semi-conducteur (1) selon l'une quelconque des revendications précédentes,
dans laquelle une partie du rayonnement (R) émis par la surface principale (3) d'un premier des éléments de surface (2) est réfléchie exactement une fois sur la surface principale (3) qui est tournée vers cette surface principale (3), d'un second des éléments de surface (3), puis un découplage de cette partie du rayonnement (R) est effectuée à partir de la source lumineuse à semi-conducteur (1).

4. Source lumineuse à semi-conducteur (1) selon l'une quelconque des revendications précédentes,
dans laquelle le diamètre moyen (L) des éléments de surface (2) est respectivement compris entre 3 cm et 30 cm.

5. Source lumineuse à semi-conducteur (1) selon l'une quelconque des revendications précédentes,

dont la caractéristique de rayonnement présente au moins un maximum d'intensité dans un domaine angulaire compris entre 25° inclus et 70°, par rapport à un angle de rayonnement relatif à la bissectrice (H).

6. Source lumineuse à semi-conducteur (1) selon l'une quelconque des revendications précédentes, dans laquelle une partie du rayonnement comprise entre 30 % inclus et 40 % du rayonnement (R) généré lors du fonctionnement est émise dans un demi-espace tourné à l'opposé des surfaces principales (3).

7. Source lumineuse à semi-conducteur (1) selon l'une quelconque des revendications précédentes, dans laquelle la caractéristique de rayonnement, vue dans une vue de dessus de la source lumineuse à semi-conducteur (1), présente un ou deux axes de symétrie (S), dans laquelle les angles à mi-hauteur ($\theta_{50}$) de la caractéristique de rayonnement le long des deux axes de symétrie (S), ou le long de l'un des axes de symétrie (S) et d'une direction perpendiculaire à celui-ci, sont différents les uns des autres, et dans laquelle les angles à mi-hauteur ($\theta_{50}$) sont les angles pour lesquels une intensité de rayonnement par rapport à une intensité de rayonnement maximale, est réduite de moitié.

8. Source lumineuse à semi-conducteur (1) selon l'une quelconque des revendications précédentes, dans laquelle une caractéristique de rayonnement des éléments de surface (2), avec une tolérance d'au plus 0,1 $I_{max}$, répond à l'équation suivante :

$$I(\beta) = I_{max} \cos(\beta),$$

dans laquelle $I_{max}$ est une intensité de rayonnement maximale en fonction de la direction, $\beta$ est un angle par rapport à une normale à l'élément de surface correspondant (2) et I est une intensité de rayonnement de l'élément de surface correspondant (2) dans une direction définie par l'angle $\beta$.

9. Source lumineuse à semi-conducteur (1) selon l'une quelconque des revendications précédentes, dans laquelle les éléments de surface (2) comprennent respectivement au moins quatre puces à semi-conducteur (5) optoélectroniques inorganiques qui recouvrent chacune au total au plus 5 % de la surface principale (3) de l'élément de surface correspondant (2).

10. Source lumineuse à semi-conducteur (1) selon l'une quelconque des revendications précédentes, dans laquelle les éléments de surface (2) réfléchissent chacun au moins partiellement un rayonnement visible de manière à ce qu'un angle d'incidence du rayonnement (R) soit égal à un angle de réflexion.

11. Source lumineuse à semi-conducteur (1) selon l'une quelconque des revendications précédentes, dans laquelle les éléments de surface (2) sont agencés de façon pyramidale, de façon hémisphérique, en toit et/ou en cube.

12. Source lumineuse à semi-conducteur (1) selon l'une quelconque des revendications précédentes, comprenant une pluralité d'éléments de surface (2), dans laquelle les éléments de surface (2) sont disposés en dents de scie lorsqu'ils sont vus en coupe transversale.

13. Source lumineuse à semi-conducteur (1) selon l'une quelconque des revendications précédentes, dans laquelle les éléments de surface (2), lorsqu'ils sont vus de dessus sur la source lumineuse à semi-conducteur (1) présentent des superficies différentes les unes des autres.

14. Source lumineuse à semi-conducteur (1) selon l'une quelconque des revendications précédentes, dans laquelle les éléments de surface (2) sont opaque au rayonnement.

FIG 1

A)

B)

FIG 2

FIG 3

FIG 4

A)

B)

## FIG 5

## FIG 6

FIG 7

FIG 8

FIG 9

FIG 10

FIG 11

A)

B)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 202008010884 U1
- EP 1569283 A1

- DE 10125341 A1